(19) Europäisches Patentamt
European Patent Office
Office européen des brevets

(11)    **EP 2 473 839 B1**

(12)    **EUROPÄISCHE PATENTSCHRIFT**

(45) Veröffentlichungstag und Bekanntmachung des Hinweises auf die Patenterteilung:
**26.03.2014   Patentblatt 2014/13**

(21) Anmeldenummer: **10744690.8**

(22) Anmeldetag: **16.08.2010**

(51) Int Cl.:
*G01N 21/64* *(2006.01)*          *G01N 21/66* *(2006.01)*
*G01R 31/26* *(2014.01)*          *H01L 21/66* *(2006.01)*

(86) Internationale Anmeldenummer:
**PCT/EP2010/005018**

(87) Internationale Veröffentlichungsnummer:
**WO 2011/023312 (03.03.2011 Gazette 2011/09)**

(54) **VERFAHREN ZUR VERMESSUNG EINER HALBLEITERSTRUKTUR, WELCHE EINE SOLARZELLE ODER EINE VORSTUFE EINER SOLARZELLE IST**

METHOD FOR MEASURING A SEMICONDUCTOR STRUCTURE, WHICH IS A SOLAR CELL OR A PRECURSOR OF A SOLAR CELL

PROCÉDÉ DE MESURE D'UNE STRUCTURE SEMI-CONDUCTRICE SOUS LA FORME D'UNE CELLULE SOLAIRE OU D'UNE ÉBAUCHE DE CELLULE SOLAIRE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **31.08.2009   DE 102009039399**

(43) Veröffentlichungstag der Anmeldung:
**11.07.2012   Patentblatt 2012/28**

(73) Patentinhaber:
• **Fraunhofer-Gesellschaft zur Förderung der angewandten Forschung e.V.**
  **80686 München (DE)**
• **Albert-Ludwigs-Universität Freiburg**
  **79098 Freiburg (DE)**

(72) Erfinder:
• **HAUNSCHILD, Jonas**
  **79115 Freiburg (DE)**
• **REIN, Stefan**
  **79211 Denzlingen (DE)**
• **GLATTHAAR, Markus**
  **79104 Freiburg (DE)**

(56) Entgegenhaltungen:
EP-A2- 1 758 178          WO-A1-2008/095467
WO-A2-2009/103566          DE-A1-102007 045 830
DE-U1-202009 017 763          US-A1- 2009 206 287

• **MARKUS GLATTHAAR ET AL: "Spatially resolved determination of the dark saturation current of silicon solar cells from electroluminescence images", JOURNAL OF APPLIED PHYSICS, AMERICAN INSTITUTE OF PHYSICS. NEW YORK, US, Bd. 105, 1. Januar 2009 (2009-01-01), Seiten 113110-1, XP007916041, ISSN: 0021-8979, DOI: DOI:10.1063/1.3132827 [gefunden am 2009-06-04] in der Anmeldung erwähnt**
• **WÜRFEL P ET AL: "Diffusion lengths of silicon solar cells from luminescence images", JOURNAL OF APPLIED PHYSICS, AMERICAN INSTITUTE OF PHYSICS. NEW YORK, US, Bd. 101, 1. Januar 2007 (2007-01-01), Seiten 123110-1, XP007916042, ISSN: 0021-8979, DOI: DOI: 10.1063/1.274920 [gefunden am 2007-06-27] in der Anmeldung erwähnt**
• **TRUPKE T ET AL: "Spatially resolved series resistance of silicon solar cells obtained from luminescence imaging", APPLIED PHYSICS LETTERS, AIP, AMERICAN INSTITUTE OF PHYSICS, MELVILLE, NY, US, Bd. 90, Nr. 9, 28. Februar 2007 (2007-02-28), Seiten 93506-093506, XP012096301, ISSN: 0003-6951, DOI: DOI: 10.1063/1.2709630 in der Anmeldung erwähnt**

- KAMPWERTH H ET AL: "Advanced luminescence based effective series resistance imaging of silicon solar cells", APPLIED PHYSICS LETTERS, AIP, AMERICAN INSTITUTE OF PHYSICS, MELVILLE, NY, US, Bd. 93, Nr. 20, 18. November 2008 (2008-11-18), Seiten 202102-202102, XP012112531, ISSN: 0003-6951, DOI: DOI: 10.1063/1.2982588
- MICHL B ET AL: "Application of Luminescence Imaging based Series Resistance Measurements Methods in an Industrial Environment", PROCEEDINGS OF THE 23RD EUROPEAN PHOTOVOLTAIC SOLAR ENERGY CONFERENCE AND EXHIBITION, VALENCIA, SPAIN, [Online] 1. September 2008 (2008-09-01), Seiten 1-6, XP002603257, Gefunden im Internet: URL:http://www.ise.fraunhofer.de/veroeffen tlichungen/nach-jahrgaengen/200 8/veroeffentlichungen/application-of-lumin escence-imaging-based-serie s-resistance-measurements-methods-in-an-in dustrial-environment/at_dow nload/file> [gefunden am 2008-09-05]
- PYSCH ET AL: "A review and comparison of different methods to determine the series resistance of solar cells", SOLAR ENERGY MATERIALS AND SOLAR CELLS, ELSEVIER SCIENCE PUBLISHERS, AMSTERDAM, NL, Bd. 91, Nr. 18, 30. August 2007 (2007-08-30), Seiten 1698-1706, XP022223139, ISSN: 0927-0248, DOI: DOI:10.1016/J.SOLMAT.2007.05.026
- RAMSPECK K ET AL: "Recombination current and series resistance imaging of solar cells by combined luminescence and lock-in thermography", APPLIED PHYSICS LETTERS, AIP, AMERICAN INSTITUTE OF PHYSICS, MELVILLE, NY, US, Bd. 90, Nr. 15, 9. April 2007 (2007-04-09) , Seiten 153502-153502, XP012094133, ISSN: 0003-6951, DOI: DOI: 10.1063/1.2721138

## Beschreibung

Die Erfindung betrifft ein Verfahren zur Vermessung einer Halbleiterstruktur gemäß Anspruch 1, wobei die Halbleiterstruktur einen Emitter und eine Basis umfasst und eine Solarzelle oder eine Vorstufe einer Solarzelle ist.

Bei Halbleiterstrukturen, die auf einem indirekten Halbleiter wie beispielsweise Silizium basieren, ist es bekannt, anhand einer in der Halbleiterstruktur erzeugten Lumineszenzstrahlung Aufschluss über die physikalischen Eigenschaften der Halbleiterstruktur zu erlangen. Insbesondere werden Messungen der Lumineszenzstrahlung dazu verwendet, bei einer Halbleiterstruktur, welche eine Solarzelle oder eine Vorstufe einer Solarzelle ist und zumindest einen Emitter und eine Basis aufweist, ortsaufgelöst elektrische Kenngrößen zu bestimmen.

Hierbei ist es bekannt, die Diffusionslänge des Halbleitermaterials aus der Messung der Lumineszenzstrahlung zu bestimmen, wie beispielsweise in Würfel, P. et al, "Diffusions lengths of silicon solar cells from luminescence images", Journal of Applied Physics, 2007. 101 (123110): p.1-10 beschrieben.

Zur Charakterisierung von Solarzellen, insbesondere zur Überprüfung der Qualität industriell hergestellter Solarzellen ist es wünschenswert, weitere elektrische Kenngrößen ortsaufgelöst zu bestimmen, insbesondere den Dunkelsättigungsstrom, den Emitterschichtwiderstand und den lokalen Serienwiderstand.

Bei Lumineszenzstrahlung, welche im Wesentlichen durch Beaufschlagen der Halbleiterstruktur mit einer Anregungsspannung erzeugt wird (so genannte "Elektrolumineszenzstrahlung") ist bekannt, aus zwei ortsaufgelösten Messungen der Elektrolumineszenz bei unterschiedlichen Messbedingungen den Dunkelsättigungsstrom ortsaufgelöst zu bestimmen. Ein solches Verfahren ist in M. Glatthaar, J. Giesecke, M. Kasemann, J. Haunschild, M. The, W. Warta, and S. Rein, Journal of Applied Physics 105, 113110/1-5 (2009) beschrieben. Dieses Messverfahren weist jedoch den Nachteil auf, dass beispielsweise der Emitterschichtwiderstand vorbekannt und darüber hinaus räumlich konstant sein muss. Insbesondere bei industriell hergestellten Solarzellen variiert der Emitterschichtwiderstand jedoch häufig entlang der Oberfläche der Solarzelle, so dass die vorgenannte Bedingung nicht erfüllt ist. Weiterhin benötigt das Verfahren eine lange Messdauer, so dass es nicht inline in einer Prozesslinie einsetzbar ist.

Der Erfindung liegt daher die Aufgabe zugrunde, ein Verfahren zur Vermessung einer Halbleiterstruktur zu schaffen, welches die ortsaufgelöste Bestimmung von Dunkelsättigungsstrom und/oder Serienwiderstand und/oder Emitterschichtwiderstand der Halbleiterstruktur mittels Lumineszenzmessung ermöglicht, ohne dass Einschränkungen derart vorliegen, dass eine der Größen vorbekannt oder räumlich konstant sein muss.

Gelöst ist diese Aufgabe durch ein Verfahren gemäß Anspruch 1. Vorteilhafte Ausgestaltungen des Verfahrens finden sich in den Ansprüchen 2 bis 15.

Die Halbleiterstruktur ist eine Solarzelle oder eine Vorstufe einer Solarzelle. Wesentlich ist, dass die Halbleiterstruktur bereits einen Emitter und eine Basis umfasst.

Das erfindungsgemäße Verfahren umfasst folgende Verfahrensschritte:

In einem Schritt A wird Lumineszenzstrahlung in der Halbleiterstruktur erzeugt und es erfolgt eine ortsaufgelöste Messung der von der Halbleiterstruktur ausgehenden Lumineszenzstrahlung. Solarzellen sind typischerweise flächige Gebilde, d. h. Vorder- und Rückseite einer Solarzelle weisen eine wesentlich größere Länge und Breite auf, verglichen mit der Dicke einer Solarzelle. Die Bezeichnung "ortsaufgelöst" bezieht sich daher im Folgenden stets auf mehrere Ortspunkte parallel zu der Vorder- und/oder Rückseite der Solarzelle, nicht jedoch eine Anordnung mehrerer Ortspunkte hinsichtlich der Tiefe der Solarzelle, d. h. entlang einer Linie senkrecht zur Vorder- oder Rückseite.

In Schritt A erfolgt mindestens eine erste ortsaufgelöste Messung der Lumineszenzstrahlung bei einer ersten Messbedingung a.

Weiterhin wird in Schritt A zumindest ein erstes ortsaufgelöstes, spannungskalibriertes Bild aus den in Schritt A erhaltenen Messdaten bestimmt. Der Begriff "spannungskalibriertes Bild" bezeichnet dabei ein ortsaufgelöstes, spannungskalibriertes Bild $V_a(x_i)$, d. h. eine Vielzahl von Spannungswerten, welche entsprechenden Ortspunkten $x_i$ der Solarzelle zugeordnet sind. Die Spannungswerte beschreiben hierbei die bei der jeweiligen Messbedingung lokal an dem Ortspunkt $x_i$ an der Halbleiterstruktur anliegende Spannung bzw. über einen sich zwischen Emitter und Basis ausbildenden pn-Übergang lokal abfallende Spannung. In Schritt B wird somit gemäß der ersten Messbedingung ein erstes, ortsaufgelöstes Spannungsbild $V_a(x_i)$ bestimmt.

In einem Schritt B werden ortsaufgelöste Eigenschaften der Halbleiterstruktur bestimmt, hinsichtlich des ortsaufgelösten Dunkelsättigungsstromes $j_o(x_i)$ und/oder des ortsaufgelösten Emitterschichtwiderstandes $\rho(x_i)$ und/oder des ortsaufgelösten, lokalen Serienwiderstandes $R_s(x_i)$ für die Vielzahl von Ortspunkten $x_i$, wobei die Bestimmung abhängig von dem in Schritt A bestimmten spannungskalibrierten Bildern erfolgt.

Wesentlich ist, dass in Schritt A zusätzlich mindestens eine zweite Messung bei einer zur ersten Messbedingung a unterschiedlichen zweiten Messbedingung b durchgeführt und abhängig zumindest von den erhaltenen Messdaten der zweiten Messung ein zweites ortsaufgelöstes, spannungskalibriertes Bild $V_b(x_i)$ für die Vielzahl von Ortspunkten $x_i$

aus den in Schritt A erhaltenen Messdaten bestimmt wird. Bei beiden Messungen in Schritt A ist die Lumineszenzstrahlung im Wesentlichen durch flächiges Beaufschlagen der Halbleiterstruktur mit einer Anregungsstrahlung erzeugt. Weiterhin unterscheiden sich die Messbedingungen der ersten und zweiten Messung hinsichtlich der Intensitäten und/oder spektralen Zusammensetzung der Anregungsstrahlung und/oder hinsichtlich einer vorgegebenen externen Spannung $V_{ext}$, mit der die Halbleiterstruktur über elektrische Kontaktierungen beaufschlagt wird.

Weiterhin wird zusätzlich zu jeder Messbedingung eine spannungsunabhängige, ortsunabhängige Kurzschlussstromdichte $j_{P,a/b}$ vorgegeben und/oder zusätzlich gemessen. Die Kurzschlussstromdichte $j_{P,a/b}$ gibt den flächennommierten Kurzschlussstrom wieder, der unter der jeweiligen Messbedingung bei Vorliegen von Kurzschlussbedingungen (d. h. kurzgeschlossenen elektrischen Kontakten) vorliegt. Sofern die Messung an einer Vorstufe einer Solarzelle durchgeführt wird, welche noch keine elektrische Kontaktierungsstrukturen aufweist, entsprechen die vorgegebenen Kurzschlussstromdichten denjenigen, die nach Fertigstellung der Solarzelle bei Vorliegen der jeweiligen Messbedingung bei Kurzschlussbedingung zwischen den elektrischen Kontakten fließen.

In Schritt B erfolgt bei dem erfindungsgemäßen Verfahren die Bestimmung der ortsaufgelösten, elektrischen Eigenschaften an jedem Ortspunkt $x_i$ abhängig von zumindest den Kurzschlussstromdichten $j_{P,a/b}$ und einer spannungsabhängigen, ortsabhängigen Dunkelstromdichte $j_{D,a/b}(x_i)$. Die Dunkelstromdichte $j_{D,a/b}(x_i)$ wird hierbei mittels eines mathematischen Modells bestimmt wird, welches zumindest abhängig von der spannungsunabhängigen Dunkelsättigungsstromdichte $j_0(x_i)$ und den beiden aus den jeweiligen spannungskalibrierten Bildern resultierenden Spannungen $V_{a/b}(x_i)$ für den jeweiligen Ort $x_i$ ist.

Das erfindungsgemäße Verfahren beruht auf der Erkenntnis des Anmelders, dass bei den zu vermessenden Halbleiterstrukturen mindestens zwei unabhängige Parameter örtliche Spannungsänderungen verursachen können, beispielsweise der lokale Serienwiderstand $R_s$ und der ortsaufgelöste Dunkelsättigungsstrom $j_0$ oder der ortsaufgelöste Emitterschichtwiderstand p und der ortsaufgelöste Dunkelsättigungsstrom $j_0$. Da sich die ortsaufgelöste, spannungsabhängige Stromdichte der Halbleiterstruktur bei Lumineszenzmessungen durch eine Summe der ortsunabhängigen, spannungsunabhängigen Kurzschlussstromdichte und der spannungsabhängigen und ortsabhängigen Dunkelstromdichte annähern lässt, ist bei dem erfindungsgemäßen Verfahren durch Verwendung mindestens zweier ortsaufgelöster, spannungskalibrierter Bilder und der Kurzschlussstromdichte $j_{P,a/b}$ die Bestimmung beider unabhängiger Parameter möglich. Dies trifft jedoch nur dann zu, wenn die Lumineszenzstrahlung im Wesentlichen mittels einer Anregungsstrahlung erzeugt wird, es sich somit um Photolumineszenzstrahlung (PL) handelt.

Im Gegensatz zu vorbekannten Verfahren wird bei dem erfindungsgemäßen Verfahren somit eine zusätzliche Information durch Vorgabe und/oder Messung der Kurzschlussstromdichte $j_{P,a/b}$ und mindestens zweier Spannungsbilder verwendet. Hieraus ergibt sich der Vorteil, dass eine Bestimmung der Dunkelsättigungsstromdichte und/oder des Emitterschichtwiderstandes und/oder des Serienwiderstandes jeweils ortsaufgelöst möglich ist, ohne dass eine dieser Größen (insbesondere die Dunkelsättigungsstromdichte) ortsunabhängig und/oder vorbekannt sein muss.

Durch das erfindungsgemäße Verfahren werden somit die Charakterisierungsmöglichkeiten bei der Analyse einer Solarzelle mittels Messung der Photolumineszenzstrahlung wesentlich erweitert. Weiterhin ist das erfindungsgemäße Verfahren mit kurzen Messdauern durchführbar, so dass es inline in einer Prozesslinie einsetzbar ist.

Vorzugsweise erfolgt in Schritt B die Bestimmung der ortsaufgelösten, elektrischen Eigenschaften an jedem Ortspunkt $x_i$ zusätzlich abhängig von einer externen Spannung $V_{ext,a}$ bei Messbedingung a und $V_{ext,b}$ bei Messbedingung b. Hierbei ist in Schritt A bei beiden Messungen die Halbleiterstruktur elektrisch kontaktiert und über die elektrische Kontaktierung wird die externe Spannung $V_{ext,a}$ bei Messbedingung a und $V_{ext,b}$ bei Messbedingung b vorgegeben. Alternativ wird für die Spannung $V_{ext,a}$ die Spannung des Ortspunktes mit der geringsten Spannung im Spannungsbild $V_a(x_i)$ vorgegeben: $V_{ext,a} = Min(V_a(x_i))$ für alle Ortspunkte $x_i$ Entsprechend wird für die externe Spannung unter Messbedingung B $V_{ext,b} = Min(V_b(x_i))$ für alle Ortspunkte $x_i$ vorgegeben. Die zweite Alternative ist insbesondere dann sinnvoll, wenn die Messung an Vorstufen einer Solarzelle durchgeführt wird, welche noch keine elektrische Kontaktierungen aufweist. Bei dieser zweiten Alternative ist somit die Solarzelle bzw. die Vorstufe der Solarzelle elektrisch nicht kontaktiert und die Werte $V_{ext,a}$ und $V_{ext,b}$ werden somit, wie oben angegeben, aus den minimalen Werten der entsprechenden Spannungsbilder ermittelt. Bei dieser zweiten Alternative liegen somit Offenklemmspannung-Messbedingungen vor.

Die Lumineszenzstrahlung wird im Wesentlichen durch flächiges Beaufschlagen der Halbleiterstruktur mit einer Anregungsstrahlung erzeugt wird. Dies bedeutet, dass die Lumineszenzstrahlung eine "Photolumineszenzstrahlung" ist. Zusätzlich ist die Halbleiterstruktur vorzugsweise elektrisch kontaktiert und mittels der elektrischen Kontaktierung ist eine externe Spannung $V_{ext}$ vorgegeben. Obwohl die Lumineszenzstrahlung im Wesentlichen durch das Beaufschlagen der Halbleiterstruktur mit Anregungsstrahlung erzeugt wird, wird bei dem erfindungsgemäßen Verfahren vorzugsweise zusätzlich der Zustand der Solarzelle durch die elektrische Kontaktierung und Vorgabe der externen Spannung vorgegeben, wodurch insbesondere auch ein Stromfluss in der Solarzelle und über die elektrische Kontaktierung definiert ist. Dies schließt auch die Vorgabe einer Spannung 0 ein. Bei dem erfindungsgemäßen Verfahren erfolgt jedoch im Gegensatz zu vorbekannten Messungen der Elektrolumineszenzstrahlung keine wesentliche Erzeugung von Lumineszenzstrahlung aufgrund des Einprägens eines Stromflusses durch eine äußere externe Spannung, sondern die Lumineszenzstrahlung wird durch die Anregungsstrahlung im Wesentlichen erzeugt und die externe Spannung dient zusätzlich zur Festlegung der Messbedingung.

Der grundsätzliche Messaufbau, insbesondere die Art und Weise der Beaufschlagung der Halbleiterstruktur mit Anregungsstrahlung und Messung der Photolumineszenzstrahlung sowie Kontaktierung der Halbleiterstruktur zur Vorgabe einer externen Spannung $V_{ext}$ erfolgt vorzugsweise in an sich bekannter Weise. Insbesondere ist die Messung der Lumineszenzstrahlung mittels einer Kamera, vorzugsweise einer CCD-Kamera, in an sich bekannter Weise vorteilhaft.

Ebenso erfolgt die Bestimmung des ersten und zweiten ortsaufgelösten, spannungskalibrierten Bildes vorzugsweise in an sich bekannter Weise, wie beispielsweise in T. Trupke, E. Pink, R. A. Bardos, and M. D. Abbott, Applied Physics Letters 90, 093506-1-3 (2007) beschrieben: In diesem Fall sind für die beiden ortsaufgelösten spannungskalibrierten Bilder mehrere ortsaufgelöste Messungen der Lumineszenzstrahlung notwendig: Gemäß T. Trupke, E. Pink, R. A. Bardos, and M. D. Abbott, Applied Physics Letters 90, 093506-1-3 (2007) kann ein PL-Bild mit Hilfe von drei weiteren PL-Bildern spannungskalibiert werden: Ein Kurzschluss- und ein Leerlaufbild bei geringer Beleuchtungsintensität, bei welchen laterale Spannungsunterschiede vernächlässigt werden können, sowie ein Kurzschlussbild bei derselben Beleuchtungsintensität wie beim zu kalibrierenden Bild. Bei der geringeren Intensität kann angenommen werden, dass die Spannung $V_i$ in jedem Bildpunkt $x_i$ gleich der angelegten Spannung $V_{ext}$ ist. Somit kann aus Formel 0 mit der thermischen Spannung $V_T$ der unbekannte Parameter $C_{v,i}$ bestimmt werden, wobei für $C_{b,i}$ die Intensität des Kurzschlussbildes bei der jeweiligen Beleuchtungsintensität zu setzen ist:

$$I_i = C_{v,i} \exp(V_i / V_T) + C_{b,i} \qquad \text{(Formel 0)}$$

Für das zu kalibrierende Bild folgt also:

$$V_i = V_T \log\left( \frac{I_i - C_{b,i}}{C_{v,i}} \right)$$

Vorzugsweise erfolgt in Schritt B für jeden Ortpunkt $x_i$ die Bestimmung der ortsaufgelösten, elektrischen Eigenschaften derart, dass ein Gleichungssystem gelöst wird, welches für jedes der beiden Spannungsbilder $V_a(x_i)$ und $V_b(x_i)$ jeweils eine Gleichung ($G_a$ und $G_b$) aufweist. Hierbei weist Gleichung $G_a$ zumindest den ortsaufgelösten, spannungsunabhängigen, lokalen Serienwiderstand $R_S(x_i)$, die Spannung $V_a(x_i)$, die externe Spannung $V_{ext,a}$, die Kurzschlussstromdichte $j_{P,a}$ und die Dunkelstromdichte $j_{D,a}(x_i)$ auf. $V_{ext,a}$ bezeichnet hierbei die bei Messbedingung a anliegende externe Spannung. Entsprechend weist die Gleichung $G_b$ zumindest $R_S(x_i)$, $V_b(x_i)$, $V_{ext,b}$, $j_{P,b}$ und $j_{P,b}(x_i)$ auf, wobei $V_{ext,b}$ die bei Messbedingung b anliegende externe Spannung bezeichnet. Es liegt ein Gleichungssystem mit zwei Gleichungen vor, bei dem $R_S(x_i)$ und $j_0(x_i)$ die Unbekannten darstellen, so dass in an sich bekannter Weise eine Bestimmung einer oder beider dieser Werte erfolgt. In dieser vorteilhaften Ausführungsform ist somit in einfacher Weise durch Anwendung an sich bekannter mathematischer Verfahren zur Lösung von Gleichungssystemen eine Bestimmung der genannten Parameter zur Charakterisierung der Solarzelle möglich.

Vorzugsweise weist Gleichung $G_a$ folgenden Aufbau auf

$$R_s(x_i) = \frac{V_{ext,a} - V_a(x_i)}{j_{P,a} + j_{D,a}(x_i)}, \qquad \text{(Formel 1a)}$$

und Gleichung $G_b$ ist entsprechend wie folgt aufgebaut:

$$R_s(x_i) = \frac{V_{ext,b} - V_b(x_i)}{j_{P,b} + j_{D,b}(x_i)}, \qquad \text{(Formel 1b)}.$$

Hierbei liegt es im Rahmen der Erfindung, dass durch übliche äquivalente Umformulierungen der Aufbau abgeändert wird. Wesentlich ist, dass das Gleichungssystem als Unbekannte lediglich $R_S(x_i)$ und $j_0(x_i)$ aufweist.

In einer weiteren vorzugsweisen Ausführungsform erfolgt in Schritt B für jeden Ortspunkt $x_i$ die Bestimmung der ortsaufgelösten, elektrischen Eigenschaften derart, dass ein Gleichungssystem gelöst wird, welches für jedes der beiden Spannungsbilder $V_a(x_i)$ und $V_b(x_i)$ jeweils eine Gleichung $G_a$, und $G_b$, aufweist, wobei Gleichung $G_a$, zumindest den ortsaufgelösten, spannungsunabhängigen Emitterschichtwiderstand $\rho(x_i)$, die Spannung $V_a(x_i)$, die externe Spannung $V_{ext,a}$, die Kurzschlussstromdichte $j_{P,a}$ und die Dunkelstromdichte $j_{D,a}(x_i)$ aufweist. Entsprechend weist Gleichung $G_b$, zumindest $\rho(x_i)$, $V_b(x_i)$, $V_{ext,b}$, $j_{P,b}$ und $j_{P,b}(x_i)$ auf.

Auch in dieser vorteilhaften Ausgestaltung liegt somit ein Gleichungssystem mit zwei Gleichungen vor, wobei in diesem Fall der Emitterschichtwiderstand $\rho(x_i)$ und die Dunkelsättigungsstromdichte $j_0(x_i)$ die beiden Unbekannten darstellen, so dass anhand des Gleichungssystems eine oder beide dieser Größen bestimmt wird.

Vorzugsweise weist die Gleichung $G_a$, hierbei folgenden Aufbau auf:

$$\nabla^2 V_a(x_i) = \rho(x_i)(j_{P,a} + j_{D,a}(x_i)) \quad \text{(Formel 2a)}$$

und entsprechend Gleichung $G_b$, folgenden Aufbau auf:

$$\nabla^2 V_b(x_i) = \rho(x_i)(j_{P,b} + j_{D,b}(x_i)) \quad \text{(Formel 2b)}.$$

Diese Gleichung wird durch Kombination des Ohmschen Gesetzes und der Kontinuitätsgleichung erhalten. Vorzugsweise wird ein etwaiges Rauschen in den Messdaten dadurch verringert, dass die zweifache Ortsableitung der Spannung gemäß des Laplace-Operators in den Formeln 2a und 2b durch die Ableitung eines quadratischen Polynoms ersetzt wird, welches mittels eines mathematischen Fitverfahrens an die Umgebung des Messpunktes angepasst wird. Diese Art der Beschreibung der zweifachen Ableitung ist an sich bekannt und beispielsweise in M. Glatthaar, J. Giesecke, M. Kasemann, J. Haunschild, M. The, W. Warta and S. Rein "Spatially resolved determination of the dark saturation current of silicon solar cells from electroluminescence images", Journal of Applied Physics 105, 113110 (2009) beschrieben. Alternativ kann auf das Bild gemäß David Marr, Ellen Catherine Hildreth, Theory of Edge Detection. In Proceedings öf the Royal Society of London. B 207, 1980, S. 187,217 der Marr-Hildreth-Operator (Laplacian of Gaussian) angewendet werden, um das Laplace-Bild zu berechnen.

Vorzugsweise wird bei dem erfindungsgemäßen Verfahren zusätzlich für jeden Ortspunkt $x_i$ und für jede der Messbedingungen a und b eine implizite Leerlaufspannung ($V_{impl,a}$, für Messbedingung a und $V_{impl,b}$ für Messbedingung b) bestimmt und weiterhin werden die spannungskalibrierten Bilder $V_a(x_i)$ und $V_b(x_i)$ zusätzlich anhand der impliziten Leerlaufspannungen bestimmt.

Vorzugsweise werden die impliziten Leerlaufspannungen wie folgt ermittelt: Mittels induktiver Messung wird für mindestens einen Ortspunkt unter Messbedingung a und für mindestens einen Ortspunkt unter Messebedingung b jeweils die implizite Leerlaufspannung für diesen Ortspunkt bestimmt. Die Bestimmung kann beispielsweise in an sich bekannter Weise wie in QSSPC, R. A. Sinton and A. Cuevas, Applied Physics Letters 69, 2510-2 (1996) beschrieben erfolgen. Da für einen Ortspunkt nun sowohl unter Messbedingung a, als auch unter Messbedingung b die Leerlaufspannung bekannt ist, kann für diesen Ortspunkt der Faktor $C_{V,i}$ gemäß Formel 0 sowohl für die Messbedingung a, als auch für die Messbedingung b berechnet werden. Da dieser Faktor ortsunabhängig ist, ist somit eine Spannungskalibrierung erfolgt und es liegen spannungskalibrierte Bilder $V_a(x_i)$ und $V_b(x_i)$ für die beiden Messbedingungen vor.

Vorzugsweise unterscheiden sich die Messbedingungen a und b durch die Intensitäten der Beleuchtung, insbesondere ist es vorteilhaft, beispielsweise eine Intensität von einer Sonne für Messbedingung a und von zwei Sonnen für Messbedingung b zu wählen, mit einer Sonne=1000 W/m$^2$.

Vorzugsweise wird bei dem erfindungsgemäßen Verfahren in Schritt A die Beleuchtungsintensität und das Spektrum der Anregungsstrahlung zwischen Messbedingung a und Messbedingung b nicht verändert, wohingegen bei Messbedingung a eine externe Spannung $V_{ext,a}$ vorgegeben ist, welche unterschiedlich zu einer bei Messbedingung b vorgegebenen externen Spannung $V_{ext,b}$ ist.

Dies weist den Vorteil auf, dass eine Änderung der externen Spannung wesentlich einfacherer und exakter realisierbar ist, verglichen mit einer definierten Änderung der Intensität oder des Spektrums der Anregungsstrahlung. In einer weiteren vorteilhaften Ausführungsform ist Messbedingung a derart gewählt, dass über die elektrische Kontaktierung ein Strom im Bereich von 15 % bis 35 %, vorzugsweise etwa 25 % des Kurzschlussstromes der Solarzelle unter Normbedingung fließt. Normbedingung bedeutet hierbei die für den Solarzellentyp geltende Normtestbedingung. Bei Siliziumsolarzellen für die Stromerzeugung aus Sonnenlicht ist dies üblicherweise eine Beleuchtungsstärke von einer Sonne (1.000 W/m$^2$) bei Spektrum AM1.5. Weiterhin ist Messbedingung b derart gewählt, dass über die elektrische Kontaktierung ein Strom im Bereich von 65 % bis 85 %, vorzugsweise etwa 75 % des Kurzschlussstromes der Solarzelle unter Normbedingungen fließen. Diese Wahl der Messbedingung weist den Vorteil auf, dass die Parameter auch für den Normbetrieb der Solarzelle relevant sind. Außerdem kommt es bei einer Sonne nur zu moderater Erwärmung der Zelle. Bei niedrigeren Intensitäten sind die Ströme geringer und damit auch die lateralen Spannungsdifferenzen aus denen die Information gewonnen wird.

Die Dunkelstromdichte $j_{D,a/b}(x_i)$ wird vorzugsweise mittels des an sich bekannten Eindiodenmodells zur Beschreibung von Solarzellen beschrieben, insbesondere gemäß der Formeln 3a und 3b:

$$j_{D,a}(x_i) = j_0(x_i)\exp(V_a(x_i)/V_T) \quad \text{(Formel 3a),}$$

$$j_{D,b}(x_i) = j_0(x_i)\exp(V_b(x_i)/V_T) \quad \text{(Formel 3b).}$$

In einer weiteren vorzugsweisen Ausführungsform des erfindungsgemäßen Verfahrens erfolgt in Schritt A zusätzlich eine weitere Messung unter einer zu den Messbedingungen a und b unterschiedlichen Messbedingungen c und in Schritt B wird entsprechend ein weiteres Spannungsbild $V_c(x_i)$ bestimmt. Weiterhin wird die Dunkelstromdichte $j_{D,a/b/d}(x_i)$ zusätzlich anhand einer weiteren Größe beschrieben und in Schritt B wird die Bestimmung der ortsaufgelösten Eigenschaften der Halbleiterstruktur abhängig zumindest von den drei Spannungsbildern $V_{a,b,c}(x_i)$ durchgeführt. In dieser vorzugsweisen Ausführungsform ist somit eine genauere Beschreibung der Dunkelstromdichte durch Aufnahme einer weiteren (unbekannten) Größe möglich, wobei die aufgrund der weiteren Größe zusätzlich benötigte Information durch das dritte Spannungsbild $V_c(x_i)$ erhalten wird. Hierdurch ist eine genauere Beschreibung der Dunkelstromdichte $j_{D,a/b/d}(x_i)$ möglich, so dass entsprechend ein genaueres Ergebnis der in Schritt B bestimmten Größe erzielt wird.

Hierbei wird vorzugsweise die Dunkelstromdichte zusätzlich durch einen spannungsunabhängigen, lokalen Parallelwiderstand $R_P(x_i)$ beschrieben, bevorzugt gemäß Formeln 4a bis 4c:

$$j_{D,a}(x_i) = j_0(x_i)\exp(V_a(x_i)/V_T) + V_a(x_i)/R_p(x_i) \quad \text{, (Formel 4a),}$$

$$j_{D,b}(x_i) = j_0(x_i)\exp(V_b(x_i)/V_T) + V_b(x_i)/R_p(x_i) \quad \text{, (Formel 4b),}$$

$$j_{D,c}(x_i) = j_0(x_i)\exp(V_c(x_i)/V_T) + V_c(x_i)/R_p(x_i) \quad \text{, (Formel 4c).}$$

Insbesondere ist es vorteilhaft, in Schritt A zusätzlich eine weitere Messung, unter einer zu den Messbedingungen a, b und c unterschiedliche Messbedingungen d aufzuführen und in Schritt B entsprechend ein viertes Spannungsbild $V_d(x_i)$ zu bestimmen und die Dunkelstromdichte $j_{D,a/b/c/d}(x_i)$ zusätzlich anhand einer weiteren Größe zu beschreiben. Entsprechend erfolgt in Schritt B die Bestimmung der ortsaufgelösten Eigenschaften der Halbleiterstruktur abhängig zumindest von den vier Spannungsbildern $V_{a,b,c,d}(x_i)$. Hierbei wird vorzugsweise die Dunkelstromdichte zusätzlich durch eine zweite Diodenabhängigkeit gemäß des an sich bekannten Zweidiodenmodells mit einem zusätzlichen Diodenfaktor 2 beschrieben, bevorzugt gemäß Formeln 5a bis 5d:

$$j_{D,a}(x_i) = j_{0,1}(x_i)\exp(V_a(x_i)/V_T) + j_{0,2}(x_i)\exp(V_a(x_i)/2/V_T) + V_a(x_i)/R_p(x_i)$$
$$\text{(Formel 5a),}$$

$$j_{D,b}(x_i) = j_{0,1}(x_i)\exp(V_b(x_i)/V_T) + j_{0,2}(x_i)\exp(V_b(x_i)/2/V_T) + V_b(x_i)/R_p(x_i)$$
$$\text{(Formel 5b),}$$

$$j_{D,c}(x_i) = j_{0,1}(x_i)\exp(V_c(x_i)/V_T) + j_{0,2}(x_i)\exp(V_c(x_i)/2/V_T) + V_c(x_i)/R_p(x_i)$$

$$\text{(Formel 5c)},$$

$$j_{D,d}(x_i) = j_{0,1}(x_i)\exp(V_d(x_i)/V_T) + j_{0,2}(x_i)\exp(V_d(x_i)/2/V_T) + V_d(x_i)/R_p(x_i)$$

$$\text{(Formel 5d)}.$$

In einer weiteren vorzugsweisen Ausführungsform des erfindungsgemäßen Verfahrens werden die in Schritt B ermittelten Spannungsbilder dadurch von weiteren Messartdefekten befreit, dass die verschmierten Lumineszenzbilder durch Scharfzeichnungsfilter (beispielsweise Wienerfilter: Norbert Wiener: Extrapolation, Interpolation, and Smoothing of Stationary Time Series. Wiley, New York 1949.) korrigiert werden.

Zur Erhöhung der Genauigkeit der bestimmten Größen ist es vorteilhaft, dass in Schritt A mindestens eine weitere Messung unter einer weiteren, zu den Messbedingungen a und b unterschiedlichen Messbedingungen durchgeführt wird mindestens ein weiteres spannungskalibriertes Bild entsprechend bestimmt wird. In Schritt B liegt in dieser vorteilhaften Ausführungsform somit ein überbestimmtes gleiches System vor, welches in an sich bekannter Weise gelöst wird, vorzugsweise nach der Methode der kleinsten Quadrate. Hierdurch wird eine höhere Genauigkeit erzielt.

Das Erzeugen und die Messung der Photolumineszenzstrahlung erfolgt vorzugsweise in an sich bekannter Weise und ist bispielsweise in Würfel, P. et al, "Diffusions lengths of silicon solar cells from luminescence images", Journal of Applied Physics, 2007. 101 (123110): p.1-10 und PCT/AU2007/001050 beschrieben.

Insbesondere ist es vorteilhaft, bei dem erfindungsgemäßen Verfahren die Lumineszenzstrahlung mittels einer Kamera, wie beispielsweise einer CCD-Kamera zu messen. Das Messsignal der Kamera ist somit ein Maß für die Intensität der Lumineszenzstrahlung. Insbesondere kann durch Verwendung einer CCD-Kamera eine ortsaufgelöste Messung der Lumineszenzstrahlung direkt (durch ein so genanntes "Mapping") erfolgen, d. h. es ist kein Abrastern oder Scannen der Oberfläche der Halbleiterstruktur notwendig.

Die Beaufschlagung der Oberfläche der Halbleiterstruktur zur Erzeugung der Photolumineszenzstrahlung erfolgt vorzugsweise mit homogener Intensität hinsichtlich der beaufschlagten Fläche der Halbleiterstruktur. Vorzugsweise wird die Halbleiterstruktur mit einem Normspektrum (beispielsweise das Spektrum AM1,5) beaufschlagt, ebenso liegt jedoch auch die Beaufschlagung mit anderen Spektren oder mit monochromatischer Anregungsstrahlung, beispielsweise durch Erzeugung mittels eines Lasers, im Rahmen der Erfindung. Ebenso ist es vorteilhaft, die Halbleiterstruktur mit unmoduliertem Licht als Anregungsstrahlung zu beaufschlagen.

Weiterhin liegt es im Rahmen der Erfindung, dass die Beaufschlagung mit Anregungsstrahlung und die Messung der Lumineszenzstrahlung der Halbleiterstruktur an derselben Oberfläche der Halbleiterstruktur erfolgt. In diesem Fall ist es wesentlich, in an sich bekannter Weise bei der Messung der Lumineszenzstrahlung optische Filter vorzuschalten, um etwaige, an der Oberfläche der Halbleiterstruktur reflektierte Anregungsstrahlung herauszufiltern. Ebenso liegt es im Rahmen der Erfindung, die Beaufschlagung mit Anregungsstrahlung einerseits und die Messung der Lumineszenzstrahlung andererseits an zwei gegenüberliegenden Oberflächen der Halbleiterstruktur vorzunehmen. Bei dieser Messkonstellation wirkt die Halbleiterstruktur selbst als Filter gegenüber der Anregungsstrahlung, so dass bei dem Messvorgang keine Störeffekte aufgrund etwaiger detektierter Anregungsstrahlung auftreten.

Die Messdaten der Lumineszenzstrahlung werden vorzugsweise durch eine Auswerteeinheit, wie beispielsweise einen Computer, ausgelesen und mittels diesem gemäß des erfindungsgemäßen Verfahrens weiter verarbeitet.

Sofern eine externe Spannung bei dem erfindungsgemäßen Messverfahren vorgegeben wird, wird diese vorzugsweise über eine steuerbare Spannungsquelle erzeugt, welche ebenfalls mit dem Computer zu deren Steuerung verbunden ist.

Vorteilhafterweise umfasst die steuerbare Spannungsquelle zusätzlich eine Strommesseinheit, welche unter Kurzschlussbedingungen den fließenden Strom misst und das Messergebnis ebenfalls an den Computer weiterleitet. Auf diese Weise kann in einfacher Weise bei den jeweils vorliegenden Messbedingen die Kurzschlussstromdichte bestimmt werden.

**Patentansprüche**

1. Verfahren zur Vermessung einer Halbleiterstruktur, welche einen Emitter und eine Basis umfasst und eine Solarzelle oder eine Vorstufe einer Solarzelle ist,
   folgende Verfahrensschritte umfassend:

A Erzeugen von Lumineszenzstrahlung in der Halbleiterstruktur und ortsaufgelöste Messung der von der Halbleiterstruktur ausgehenden Lumineszenzstrahlung wobei eine erste Messung bei einer ersten Messbedingung a durchgeführt wird und abhängig zumindest von den erhaltenen Messdaten der ersten Messung ein erstes ortsaufgelöstes, spannungskalibriertes Bild $V_a(x_i)$ für eine Vielzahl von Ortspunkten $x_i$ der Solarzelle aus den in Schritt A erhaltenen Messdaten bestimmt wird,

B Bestimmen von ortsaufgelösten Eigenschaften der Halbleiterstruktur, hinsichtlich des ortsaufgelösten Dunkelsättigungsstromes $j_0(x_i)$ und/oder des ortsaufgelösten Emitterschichtwiderstandes $\rho(x_i)$ und/oder des ortsaufgelösten, lokalen Serienwiderstandes $R_s(x_i)$ für die Vielzahl von Ortspunkten $x_i$ abhängig zumindest von dem in Schritt A bestimmten ersten Spannungsbild $V_a(x_i)$,

**dadurch gekennzeichnet,**

**dass** in Schritt A zusätzlich mindestens eine zweite Messung bei einer zur ersten Messbedingung a unterschiedlichen zweiten Messbedingung b durchgeführt und abhängig zumindest von den erhaltenen Messdaten der zweiten Messung ein zweites ortsaufgelöstes, spannungskalibriertes Bild $V_b(x_i)$ für die Vielzahl von Ortspunkten $x_i$ aus den in Schritt A erhaltenen Messdaten bestimmt wird,

**dass** in Schritt A bei beiden Messungen

- die Lumineszenzstrahlung im Wesentlichen durch flächiges Beaufschlagen der Halbleiterstruktur mit einer Anregungsstrahlung erzeugt wird,
- die Messbedingungen (a, b) der ersten und zweiten Messung sich hinsichtlich der Intentsitäten und/oder spektralen Zusammensetzungen der Anregungsstrahlung und/oder einer vorgegebenen externen Spannung $V_{ext}$, mit der die Halbleiterstruktur über elektrische Kontaktierung beaufschlagt wird, unterscheiden,

**dass** zusätzlich zu jeder Messbedingung (a,b) jeweils eine spannungsunabhängige, ortsunabhängige Kurzschlussstromdichte ($j_{P,a}$, $j_{P,b}$) des unter der jeweiligen Messbedingung bei vorliegen von Kurzschlussbedingungen fließenden Stromes vorgegeben und/oder gemessen wird und

**dass** in Schritt B die Bestimmung der ortsaufgelösten, elektrischen Eigenschaften an jedem Ortspunkt $x_i$ abhängig von zumindest den Kurzschlussstromdichten ($j_{P,a}$, $j_{P,b}$) und einer spannungsabhängigen, ortsabhängigen Dunkelstromdichte ($j_{D,a}(x_i)$, $j_{D,b}(x_i)$) für jede Messbedingung erfolgt, wobei die Dunkelstromdichten ($j_{D,a}(x_i)$, $j_{D,b}(x_i)$) zumindest abhängig von der spannungsunabhängigen Dunkelsättigungsstromdichte $j_0(x_i)$ und den beiden aus den jeweiligen Spannungsbildern resultierenden Spannungen ($V_a(x_i)$, $V_b(x_i)$) für den Ort $x_i$ sind.

2. Verfahren nach Anspruch 1,
**dadurch gekennzeichnet,**
**dass** in Schritt B die Bestimmung der ortsaufgelösten, elektrischen Eigenschaften an jedem Ortspunkt $x_i$ zusätzlich abhängig von externen Spannungen $V_{ext,a}$ bei Messbedingung a und $V_{ext,b}$ bei Messbedingung b erfolgt, wobei

- in Schritt A bei beiden Messungen die Halbleiterstruktur elektrisch kontaktiert ist und über die elektrische Kontaktierung die externe Spannung $V_{ext,a}$ bei Messbedingung a und die externe Spannung $V_{ext,b}$ bei Messbedingung b vorgegeben ist oder
- für die Spannung $V_{ext,a}$ die Spannung des Ortspunktes mit der geringsten Spannung im Spannungsbild $V_a(x_i)$ vorgegeben wird:

$V_{ext,a}$ = Min($V_a(x_i)$) für alle Ortspunkte $x_i$ und entsprechend
$V_{ext,b}$ = Min($V_b(x_i)$) für alle Ortspunkte $x_i$.

3. Verfahren nach Anspruch 2,
**dadurch gekennzeichnet,**
**dass** in Schritt B für jeden Ortspunkt $x_i$ die Bestimmung der ortsaufgelösten, elektrischen Eigenschaften derart erfolgt, dass ein Gleichungssystem gelöst wird, welches für jedes der beiden Spannungsbilder $V_a(x_i)$ und $V_b(x_i)$ jeweils eine Gleichung ($G_a$ und $G_b$) aufweist, wobei Gleichung $G_a$ zumindest den ortsaufgelösten, spannungsunabhängigen, lokalen Serienwiderstand $R_s(x_i)$, die Spannung $V_a(x_i)$, die externe Spannung $V_{ext,a}$, der Kurzschlussstromdichte $j_{P,a}$ und die Dunkelstromdichte $j_{D,a}(x_i)$ aufweist und entsprechend $G_b$ zumindest von $R_S(x_i)$, $V_b(x_i)$, $V_{ext,b}$, $j_{P,b}$ und $j_{D,b}(x_i)$ aufweist und
**dass** mittels des Gleichungssystems $R_S(x_i)$ und/oder $j_0(x_i)$ bestimmt wird.

4. Verfahren nach Anspruch 3,
**dadurch gekennzeichnet,**

**dass** die Gleichung $G_a$ einen Aufbau gemäß Formel 1a aufweist:

$$R_s(x_i) = \frac{V_{ext,a} - V_a(x_i)}{j_{P,a} + j_{D,a}(x_i)}, \quad \text{(Formel 1a)}$$

und $G_b$ einen Aufbau gemäß Formel 1 b aufweist:

$$R_s(x_i) = \frac{V_{ext,b} - V_b(x_i)}{j_{P,b} + j_{D,b}(x_i)}, \quad \text{(Formel 1b)}.$$

**5.** Verfahren nach mindestens einem der Ansprüche 1 bis 2,
   **dadurch gekennzeichnet,**
   **dass** in Schritt B für jeden Ortspunkt $x_i$ die Bestimmung der ortsaufgelösten, elektrischen Eigenschaften derart erfolgt, dass ein Gleichungssystem gelöst wird, welches für jedes der beiden Spannungsbilder $V_a(x_i)$ und $V_b(x_i)$ jeweils eine Gleichung ($G_{a'}$ und $G_{b'}$) aufweist, wobei Gleichung $G_{a'}$ zumindest den ortsaufgelösten, spannungsunabhängigen Emitterschichtwiderstandes $\rho(x_i)$, die Spannung $V_a(x_i)$, die Kurzschlussstromdichte $j_{P,a}$ und der Dunkelstromdichte $j_{D,a}(x_i)$ aufweist und entsprechend $G_{b'}$ zumindest von $\rho(x_i)$, $V_b(x_i)$, $j_{P,b}$ und $j_{P,b}(x_i)$ aufweist und
   **dass** mittels des Gleichungssystems $\rho(x_i)$ und/oder $j_o(x_i)$ bestimmt wird.

**6.** Verfahren nach Anspruch 5,
   **dadurch gekennzeichnet,**
   **dass** die Gleichung $G_{a'}$ einen Aufbau gemäß Formel 2a aufweist:

$$\nabla^2 V_a(x_i) = \rho(x_i)(j_{P,a} + j_{D,a}(x_i)), \text{(Formel 2a)}$$

und die Gleichung $G_{b'}$ einen Aufbau gemäß Formel 2b aufweist:

$$\nabla^2 V_b(x_i) = \rho(x_i)(j_{P,b} + j_{D,b}(x_i)), \text{(Formel 2b)}.$$

**7.** Verfahren nach Anspruch 6,
   **dadurch gekennzeichnet,**
   **dass** ein Rauschen in den Messdaten dadurch verringert wird, dass die zweifache Ableitung gemäß des Laplace-Operators in den Formeln 2a und 2b durch die Ableitung eines Polynoms ersetzt wird, welches mittels eine mathematischen Fitverfahrens bestimmt wird, oder indem der Marr-Hildreth-Operator auf das Bild angewendet wird.

**8.** Verfahren nach mindestens einem der Ansprüche 4 bis 7,
   **dadurch gekennzeichnet,**
   **dass** zusätzlich für jeden Ortspunkt $x_i$ und für jede der Messbedingungen a und b eine implizite Leerlaufspannung ($V_{impl,a}$, $V_{impl,b}$) bestimmt wird und die Spannungskalibrierten Bilder $V_a(x_i)$ und $V_b(x_i)$ zusätzlich anhand der impliziten Leerlaufspannungen bestimmt werden.

**9.** Verfahren mindestens nach Anspruch 2,
   **dadurch gekennzeichnet,**
   **dass** in Schritt A bei Messbedingung a die Beleuchtungsintensität und das Spektrum der Anregungsstrahlung im Wesentlichen gleich ist wie bei Messbedingung b, wohingegen bei Messbedingung a eine externe Spannung $V_{ext,a}$ vorgegeben ist, welche unterschiedlich zu einer bei Messbedingung b vorgegebenen externen Spannung $V_{ext,b}$ ist.

**10.** Verfahren nach mindestens einem der vorangegangenen Ansprüche,
   **dadurch gekennzeichnet,**
   **dass** die Halbleiterstruktur eine Solarzelle oder eine Vorstufe einer Solarzelle ist und

**dass** in Schritt A Messbedingung a derart gewählt ist, dass über die elektrische Kontaktierung ein Strom im Bereich von 15% bis 35%, vorzugsweise etwa 25% des Kurzschlussstromes der Solarzelle unter Normbedingung fließen und Messbedingung b derart gewählt ist, dass über die elektrische Kontaktierung ein Strom im Bereich von 65% bis 85%, vorzugsweise etwa 75% des Kurzschlussstromes der Solarzelle unter Normbedingung fließen.

11. Verfahren nach mindestens einem der vorangegangen Ansprüche,
**dadurch gekennzeichnet,**
**dass** die Dunkelstromdichten $(j_{D,a}(x_i), j_{D,b}(x_i))$, mittels eines Eindiodenmodells beschrieben werden, insbesondere gemäß der Formeln 3a und 3b:

$$j_{D,a}(x_i) = j_0(x_i)\exp(V_a(x_i)/V_T),\ \text{(Formel 3a)},$$

$$j_{D,b}(x_i) = j_0(x_i)\exp(V_b(x_i)/V_T),\ \text{(Formel 3b)}.$$

12. Verfahren nach mindestens einem der vorangegangenen Ansprüche, **dadurch gekennzeichnet,**
**dass** in Schritt A zusätzlich eine weitere Messung unter einer zu den Messbedingungen a und b unterschiedlichen Messbedingung c durchgeführt ein weiteres Spannungsbild $V_c(x_i)$ bestimmt wird, dass die Dunkelstromdichten zusätzlich anhand einer weiteren Größe beschrieben wird und in Schritt B die Bestimmung der ortsaufgelösten Eigenschaften der Halbleiterstruktur abhängig zumindest von den drei Spannungsbildern erfolgt, vorzugsweise,
**dass** die Dunkelstromdichten zusätzlich durch einen spannungsunabhängigen, lokalen Parallelwiderstand $R_P(x_i)$ beschrieben wird, bevorzugt gemäß Formeln 4a bis 4c:

$$j_{D,a}(x_i) = j_0(x_i)\exp(V_a(x_i)/V_T) + V_a(x_i)/R_p(x_i)\ ,\ \text{(Formel 4a)},$$

$$j_{D,b}(x_i) = j_0(x_i)\exp(V_b(x_i)/V_T) + V_b(x_i)/R_p(x_i)\ ,\ \text{(Formel 4b)},$$

$$j_{D,c}(x_i) = j_0(x_i)\exp(V_c(x_i)/V_T) + V_c(x_i)/R_p(x_i)\ ,\ \text{(Formel 4c)}.$$

13. Verfahren nach Anspruch 12,
**dadurch gekennzeichnet,**
**dass** in Schritt A zusätzlich eine weitere Messung unter einer zu den Messbedingungen a, b und c unterschiedlichen Messbedingung d durchgeführt und in Schritt A ein weiteres Spannungsbild $V_d(x_i)$ bestimmt wird, dass die Dunkelstromdichten zusätzlich anhand einer weiteren Größe beschrieben wird und in Schritt C die Bestimmung der ortsaufgelösten Eigenschaften der Halbleiterstruktur abhängig zumindest von den vier Spannungsbildern erfolgt, vorzugsweise,
**dass** die Dunkelstromdichte zusätzlich durch eine zweite Diodenabhängigkeit mit einem Diodenfaktor 2 beschrieben wird, bevorzugt gemäß der Formeln 5a bis 5d:

$$j_{D,a}(x_i) = j_{0,1}(x_i)\exp(V_a(x_i)/V_T) + j_{0,2}(x_i)\exp(V_a(x_i)/2/V_T) + V_a(x_i)/R_p(x_i)$$

$$\text{(Formel 5a)},$$

$$j_{D,b}(x_i) = j_{0,1}(x_i)\exp(V_b(x_i)/V_T) + j_{0,2}(x_i)\exp(V_b(x_i)/2/V_T) + V_b(x_i)/R_p(x_i)$$

(Formel 5b),

$$j_{D,c}(x_i) = j_{0,1}(x_i)\exp(V_c(x_i)/V_T) + j_{0,2}(x_i)\exp(V_c(x_i)/2/V_T) + V_c(x_i)/R_p(x_i)$$

(Formel 5c),

$$j_{D,d}(x_i) = j_{0,1}(x_i)\exp(V_d(x_i)/V_T) + j_{0,2}(x_i)\exp(V_d(x_i)/2/V_T) + V_d(x_i)/R_p(x_i)$$

(Formel 5d).

**14.** Verfahren nach mindestens einem der vorangegangenen Ansprüche,
**dadurch gekennzeichnet,**
**dass** die in Schritt A ermittelten Spannungsbilder dadurch von Messrauschen und weiteren Messartdefekten befreit werden, dass die verschmierten Lumineszenzbilder durch Scharfzeichnungsfilter, vorzugsweise Wienerfilter, korrigiert werden.

**15.** Verfahren nach mindestens Anspruch 3 oder 5,
**dadurch gekennzeichnet,**
**dass** in Schritt A mindestens eine weitere Messung unter einer weiteren, zu den Messbedingungen a und b unterschiedlichen Messbedingung durchgeführt und mindestens ein weiteres spannungskalibriertes Bild bestimmt und in Schritt B ein überbestimmtes Gleichungssystem gelöst wird, vorzugsweise nach der Methode der kleinsten Quadrate.

**Claims**

**1.** A method of measuring a semiconductor structure, which includes an emitter and a base, and is solar cell or a precursor of a solar cell, including the following method steps:

A producing luminescence radiation in the semiconductor structure and spatially resolved measurement of the luminescence radiation emanating from the semiconductor structure, wherein a first measurement is performed at a first measurement condition a and depending at least on the measurement data obtained in the first measurement a first spatially resolved, voltage-calibrated image $V_a(x_i)$ for a plurality of spatial points $x_i$ of the solar cell is determined from the measurement data obtained in step A,
B determining spatially resolved properties of the semiconductor structure with regard to the spatially resolved dark saturation current $j_o(x_i)$ and/or the spatially resolved emitter layer resistance $\rho(x_i)$ and/or the spatially resolved, local series resistance $R_s(x_i)$ for the plurality of spatial points $x_i$ dependent at least on the first voltage image $V_a(x_i)$ determined in step A.
**characterised in that**,
in step A at least one second measurement is additionally performed at a second measurement condition b different to the first measurement condition a and dependent at least on the measurement data obtained from the second measurement a second spatially resolved, voltage-calibrated image $V_b(x_i)$ for the plurality of spatial points $x_i$ is determined from the measurement data obtained in step A,
that in both measurements in step A

- the luminescence radiation is produced substantially by surface impingement of the semiconductor structure with an excitation radiation,
- the measurement conditions (a, b) of the first and second measurements differ as regards the intensities and/or spectral compositions of the excitation radiation and/or a predetermined external voltage $V_{ext}$ which acts on the semiconductor structure via electrical contact,

that additionally for each measurement condition (a, b) a voltage-independent, spatially independent short-circuit current density $(j_{P,a}, j_{P,b})$ of the current flowing under each of the measurement conditions when short-circuit conditions are present is predetermined and/or measured and that in step B the determination of the spatially resolved, electrical properties at each spatial point $x_i$ is effected in dependence on at least short-circuit current densities $(j_{P,a}, j_{P,b})$ and a voltage-dependent, spatially dependent dark current density $(j_{D\cdot a}(x_i), j_{D\cdot b}(x_i))$ for each measurement condition, wherein the dark current densities $(j_{D\cdot a}(x_i), j_{D\cdot b}(x_i))$ are dependent at least on the voltage-independent dark saturation current density $j_o(x_i)$ and the two voltages $(V_a(x_i), V_b(x_i))$ for the position $x_i$ resulting from the two voltage images.

2.  A method as claimed in claim 1, **characterised in that** in step B the determination of the spatially resolved, electrical properties at each spatial point $x_i$ is effected additionally in dependence on external voltages $V_{ext,a}$ under a measurement condition a and $V_{ext,b}$ under measurement conditions b, wherein

    - in both measurements, in step A the semiconductor structure is electrically contacted and the external voltage $V_{ext,a}$ under measurement conditions a and the external voltage $V_{ext,b}$ under measurement condition b is predetermined via the electrical contact or
    - for the voltage $V_{ext,a}$ the voltage of the spatial point is predetermined with the lowest voltage in the voltage image $V_a(x_i)$:

    $$V_{ext,a} = Min(V_a(x_i)) \text{ for all spatial points } x_i$$

    and correspondingly

    $$V_{ext,b} = Min(V_b(x_i)) \text{ for all spatial points } x_i.$$

3.  A method as claimed in claim 2,
    **characterised in that**,
    for each spatial point $x_i$, in step B the determination of the spatially resolved electrical properties is effected such that a system of equations is solved, which for each of the two voltage images $V_a(x_i)$ and $V_b(x_i)$ has a respective equation ($G_a$ and $G_b$), wherein equation $G_a$ comprises at least the spatially resolved, voltage-independent local series resistance $R_s(x_i)$, the voltage $V_a(x_i)$, the short circuit current density $j_{P,a}$ and the dark current density $j_{D,a}(x_i)$ and correspondingly $G_b$ comprises at least $R_s(x_i)$, $V_b(x_i)$, $V_{ext,b}$, $j_{P,b}$ and $j_{D,b}(x_i)$ and that $R_s(x_i)$ and/or $j_o(x_i)$ is determined by means of the equation system.

4.  A method as claimed in claim 3, **characterised in that** the equation $G_a$ has a structure in accordance with formula 1 a:

    $$\nabla^2 V_a(x_i) = \rho(x_i)(j_{P,a} + j_{D,a}(x_i)), \quad \text{(Formula 1a)}$$

    And $G_b$ has a structure in accordance with formula 1 b:

    $$\nabla^2 V_b(x_i) = \rho(x_i)(j_{P,b} + j_{D,b}(x_i)), \quad \text{(Formula 1b)}$$

5.  A method as claimed in at least one of claims 1 to 2, **characterised in that** for each spatial point $x_i$ in step B the determination of the spatially resolved, electrical properties is effected such that an equation system is solved, which has a respective equation ($G_a'$ and $G_b'$) for each of the two voltage images $V_a(x_i)$ and $V_b(x_i)$ wherein equation $G_a'$ comprises at least the spatially resolved, voltage-independent emitter layer resistance $\rho(x_i)$, the voltage $V_a(x_i)$, the short circuit current density $j_{P,a}$ and the dark current density $j_{D,a}(x_i)$ and correspondingly $G_b'$ comprises at least $\rho(x_i)$, $V_b(x_i)$, $j_{P,b}$ and $j_{P,b}(x_i)$ and that $\rho(x_i)$ and/or $j_o(x_i)$ is determined by means of the equation system.

6. A method as claimed in claim 5, **characterised in that** the equation $G_a$' has structure in accordance with formula 2a:

$$\nabla^2 V_a(x_i) = \rho(x_i)(j_{P,a} + j_{D,a}(x_i)),$$ (Formula 2a)

and the equation $G_b$' has a structure in accordance with formula 2b

$$\nabla^2 V_b(x_i) = \rho(x_i)(j_{P,b} + j_{D,b}(x_i)),$$ (Formula 2b)

7. A method as claimed in claim 6, **characterised in that** noise in the measurement data is reduced by the dual derivation in accordance with the Laplace-Operator in formulas 2a and 2b being replaced by the derivation of a polynomial, which is determined by means of a mathematical fit process or by using the Marr-Hildreth-Operator on the image.

8. A method as claimed in one of claims 4 to 7, **characterised in that** additionally for each spatial point $X_i$ and for each of the measurement conditions a and b an implicit open circuit voltage ($V_{impl,a}$, $V_{impl,b}$) is determined and the voltage calibrated images $V_a(x_i)$ and $V_b(x_i)$ are additionally determined with reference to the implicit open circuit voltages.

9. A method as claimed in one at least claim 2, **characterised in that** in step A, under measurement condition a the illumination intensity and the spectrum of the excitation radiation is substantially the same as in measurement condition b, whereas under measurement condition a an external voltage $V_{ext,a}$ is predetermined, which is different to an external predetermined voltage $V_{ext,b}$ predetermined under measurement condition b.

10. A method as claimed in at least one of the preceding claims, **characterised in that** the semiconductor structure is solar cell or a precursor of a solar cell and that in step A measurement condition a is so selected that a current in the range of 15% to 35%, preferably about 25%, of the short circuit current of the solar cell flows via the electrical contact under normal conditions and measurement condition b is so selected that a current in the range of 65% to 85% preferably about 75%, of the short circuit current of the solar cell under normal conditions flows via the electrical contact.

11. A method as claimed in at least one of the preceding claims, **characterised in that** the dark current densities ($j_{D,a}(x_i)$, $j_{D,b}(x_i)$) are described by means of a one diode model equation, particularly in accordance with formulas 3a and 3b:

$$j_{D,a}(x_i) = j_0(x_i)exp(V_a(x_i)/V_T),$$ (Formula 3a)

$$j_{D,b}(x_i) = j_0(x_i)exp(V_b(x_i)/V_T),$$ (Formula 3b)

12. A method as claimed in at least one of the preceding claims, **characterised in that** in step A a further measurement is additionally performed under measurement condition c different to the measurement conditions a and b and a further voltage image $V_c(x_i)$ is determined, that the dark current densities are additionally described by way of a further parameter and in step B the determination of the spatially resolved properties of the semiconductor structure is effected in dependence on at least three voltage images, preferably, that the dark current densities are additionally described by a voltage-independent, local parallel resistance $R_p(x_i)$, preferably in accordance with formulas 4a to 4c:

$$j_{D,a}(x_i) = j_0(x_i)\exp(V_a(x_i)/V_T) + V_a(x_i)/R_p(x_i).$$ (Formula 4a)

$$j_{D,b}(x_i) = j_0(x_i)\exp(V_b(x_i)/V_T) + V_b(x_i)/R_p(x_i)$$ , (Formula 4b)

$$j_{D,c}(x_i) = j_0(x_i)\exp(V_c(x_i)/V_T) + V_c(x_i)/R_p(x_i)$$ , (Formula 4c)

13. A method as claimed in claim 12, **characterised in that** in step A the further measurement is additionally performed under measurement condition d different to measurement conditions a, b and c and in step A a further voltage image $V_d(x_i)$ is determined, that the dark current densities are additionally described with reference to a further parameter and in step C the determination of the spatially resolved properties of the semiconductor structure is effected in dependence on at least the four voltage images, preferably, that the dark current density is additionally described by a second diode dependency with a diode factor of 2, preferably in accordance with the formulas 5a to 5d:

$$j_{D,a}(x_i) = j_{0,1}(x_i)\exp(V_a(x_i)/V_T) + j_{0,2}(x_i)\exp(V_a(x_i)/2/V_T) + V_a(x_i)/R_p(x_i)$$

(Formula 5a),

$$j_{D,b}(x_i) = j_{0,1}(x_i)\exp(V_b(x_i)/V_T) + j_{0,2}(x_i)\exp(V_b(x_i)/2/V_T) + V_b(x_i)/R_p(x_i)$$

(Formula 5b),

$$j_{D,c}(x_i) = j_{0,1}(x_i)\exp(V_c(x_i)/V_T) + j_{0,2}(x_i)\exp(V_c(x_i)/2/V_T) + V_c(x_i)/R_p(x_i)$$

(Formula 5c),

$$j_{D,d}(x_i) = j_{0,1}(x_i)\exp(V_d(x_i)/V_T) + j_{0,2}(x_i)\exp(V_d(x_i)/2/V_T) + V_d(x_i)/R_p(x_i)$$

(Formula 5d).

14. A method as claimed in at least one of the preceding claims, **characterised in that** the voltage images determined in step A are freed of measurement noise and further measuring mode defects by the blurred luminescence images being corrected by sharpness filters, preferably by Wiener filters.

15. A method as claimed in one of claims 3 or 5, **characterised in that** in step A at least one further measurement is performed under further measurement conditions different to measurement conditions a and b and at least one further voltage-calibrated image is determined and in step B an over determined equation system is solved, preferably by the least squares method.

**Revendications**

1. Procédé de mesure d'une structure semi-conductrice, laquelle comprend un émetteur et une base et est une cellule solaire ou un précurseur d'une cellule solaire,
lequel procédé consiste à :

A générer un rayonnement luminescent dans la structure semi-conductrice et réaliser une mesure à résolution locale du rayonnement luminescent provenant de la structure semi-conductrice, une première mesure étant réalisée dans une première condition de mesure a et, en fonction au moins des données obtenues lors de la première mesure, une première image calibrée en tension $V_a(x_i)$ à résolution locale étant déterminée à partir des données de mesure obtenues à l'étape A pour une pluralité de points locaux $x_i$ de la cellule solaire,

B déterminer les caractéristiques à résolution locale de la structure semiconductrice en ce qui concerne le courant de saturation à l'obscurité $j_0(x_i)$ à résolution locale et/ou la résistance de couche d'émetteur $\rho(x_i)$ à résolution locale et/ou la résistance série locale $R_s(x_i)$ à résolution locale pour la pluralité de points locaux $x_i$ en fonction au moins de la première image de tension $V_a(x_i)$ déterminée à l'étape A,

**caractérisé en ce**

**qu**'à l'étape A, on effectue en plus au moins une deuxième mesure dans une deuxième condition b différente de la première condition de mesure a et, en fonction au moins des données obtenues lors de la deuxième mesure, on détermine à partir des données de mesure obtenues à l'étape A une deuxième image calibrée en tension $V_b(x_i)$ à résolution locale pour la pluralité de points locaux $x_i$,

**qu**'à l'étape A, lors des deux mesures,

- le rayonnement luminescent est généré sensiblement en soumettant la surface de la structure semi-conductrice à un rayonnement d'excitation,
- les conditions de mesure (a, b) des première et deuxième mesures se différencient en ce qui concerne les intensités et/ou les compositions spectrales du rayonnement d'excitation et/ou une tension externe prédéfinie $V_{ext}$ à laquelle la structure semi-conductrice est soumise par contact électrique,

**qu**'en plus de chaque condition de mesure (a, b), une densité de courant de court-circuit ($j_{P,a}$, $j_{P,b}$), indépendante de la tension et du lieu, du courant circulant dans la condition de mesure respective dans des conditions de court-circuit, est chaque fois prédéfinie et/ou mesurée et

**qu**'à l'étape B, les caractéristiques électriques à résolution locale sont déterminées à chaque point local $x_i$ en fonction au moins des densités de courant de court-circuit ($j_{P,a}$, $j_{P,b}$) et d'une densité de courant à l'obscurité ($j_{D,a}(x_i)$, $j_{D,b}(x_i)$) dépendante de la tension et du lieu pour chaque condition de mesure, les densités de courant à l'obscurité ($j_{D,a}(x_i)$, $j_{D,b}(x_i)$) dépendant au moins de la densité de courant de saturation à l'obscurité $j_0(x_i)$ indépendante de la tension et des deux tensions ($V_a(x_i)$, $V_b(x_i)$) résultant des images de tension respectives pour le point $x_i$.

2. Procédé selon la revendication 1,
   **caractérisé en ce**
   **qu**'à l'étape B, les caractéristiques électriques à résolution locale à chaque point local $x_i$ sont déterminées en plus en fonction de tensions externes $V_{ext,a}$ dans la condition de mesure a et $V_{ext,b}$ dans la condition de mesure b, sachant que

   - à l'étape A, lors des deux mesures, la structure semi-conductrice est contactée électriquement et la tension externe $V_{ext,a}$ dans la condition de mesure a et $V_{ext,b}$ dans la condition de mesure b sont prédéfinies par le contact électrique ou
   - Pour la tension $V_{ext,a}$, la tension du point local est prédéfinie par la plus faible tension dans l'image de tension $V_a(x_i)$ :

   $V_{ext,a} = Min(V_a(x_i))$ *pour tous les points locaux* $x_i$ *et, de façon correspondante,*
   $V_{ext,b} = Min(V_b(x_i))$ *pour tous les points locaux* $x_i$.

3. Procédé selon la revendication 2,
   **caractérisé en ce**
   **qu**'à l'étape B, pour chaque point local $x_i$, les caractéristiques électriques à résolution locale sont déterminées en résolvant un système d'équations, lequel présente une équation ($G_a$ et $G_b$) pour chacune des deux images de tension $V_a(x_i)$ et $V_b(x_i)$, l'équation $G_a$ présentant au moins la résistance série locale $R_s(x_i)$ à résolution locale indépendante de la tension, la tension $V_a(x_i)$, la tension externe $V_{ext,a}$, la densité de courant de court-circuit $j_{P,a}$ et la densité de courant à l'obscurité $j_{D,a}(x_i)$ et, de façon correspondante $G_b$ au moins $R_s(x_i)$, $V_b(x_i)$, $V_{ext,b}$, $j_{P,b}$ et $j_{D,b}(x_i)$ et **que** $R_s(x_i)$ et/ou $j_0(x_i)$ sont déterminés au moyen du système d'équations.

4. Procédé selon la revendication 3,
   **caractérisé en ce**
   **que** l'équation $G_a$ présente une structure selon la formule la :

$$R_s(x_i) = \frac{V_{ext,a} - V_a(x_i)}{j_{P,a} + j_{D,a}(x_i)}, \text{ (formule 1a)}$$

et $G_b$ une structure selon la formule 1b :

$$R_s(x_i) = \frac{V_{ext,b} - V_b(x_i)}{j_{P,b} + j_{D,b}(x_i)}, \text{ (formule 1b)}.$$

5. Procédé selon au moins une des revendications 1 à 2,
   **caractérisé en ce**
   **qu'**à l'étape B, pour chaque point local $x_i$, les caractéristiques électriques à résolution locale sont déterminées en résolvant un système d'équations, lequel présente une équation ($G_a$' et $G_b$') pour chacune des deux images de tension $V_a(x_i)$ et $V_b(x_i)$, l'équation $G_a$' présentant au moins la résistance de couche d'émetteur $\rho(x_i)$ à résolution locale indépendante de la tension, la tension $V_a(x_i)$, la densité de courant de court-circuit $j_{P,a}$ et la densité de courant à l'obscurité $j_{D,a}(x_i)$ et, de façon correspondante $G_b$' au moins $\rho(x_i)$, $V_b(x_i)$, $j_{P,b}$ et $j_{D,b}(x_i)$ et
   **que** $\rho(x_i)$ et/ou $j_0(x_i)$ sont déterminés au moyen du système d'équations.

6. Procédé selon la revendication 5,
   **caractérisé en ce**
   **que** l'équation $G_a$' présente une structure selon la formule 2a :

$$\nabla^2 V_a(x_i) = \rho(x_i)(j_{P,a} + j_{D,a}(x_i)), \text{ (formule 2a)}$$

et l'équation $G_b$' une structure selon la formule 2b :

$$\nabla^2 V_b(x_i) = \rho(x_i)(j_{P,b} + j_{D,b}(x_i)), \text{ (formule 2b)}.$$

7. Procédé selon la revendication 6,
   **caractérisé en ce**
   **qu'**un bruit dans les données de mesure est diminué en remplaçant la dérivée seconde selon l'opérateur de Laplace dans les formules 2a et 2b par la dérivée d'un polynôme qui est déterminé au moyen d'un procédé mathématique d'ajustement ou en appliquant l'opérateur de Marr-Hildreth sur l'image.

8. Procédé selon au moins une des revendications 4 à 7,
   **caractérisé en ce**
   **qu'**une tension implicite de circuit ouvert ($V_{impl,a}$, $V_{impl,b}$) est déterminée en plus pour chaque point local $x_i$ et pour chacune des conditions de mesure a et b et les images calibrées en tension $V_a(x_i)$ et $V_b(x_i)$ sont en plus déterminées à l'aide des tensions implicites de circuit ouvert.

9. Procédé selon au moins la revendication 2,
   **caractérisé en ce**
   **qu'**à l'étape A, dans la condition de mesure a, l'intensité lumineuse et le spectre du rayonnement d'excitation sont sensiblement les mêmes que dans la condition de mesure b, tandis que dans la condition de mesure a est prédéfinie une tension externe $V_{ext,a}$ qui est différente d'une tension externe $V_{ext,b}$ qui est prédéfinie dans la condition de mesure b.

10. Procédé selon au moins une des revendications précédentes,
    **caractérisé en ce**
    **que** la structure semi-conductrice est une cellule solaire ou un précurseur d'une cellule solaire et
    **qu'**à l'étape A, la condition de mesure a est choisie de façon que par le contact électrique il circule un courant de l'ordre de 15 % à 35 %, de préférence d'environ 25 % du courant de court-circuit de la cellule solaire dans des conditions normales et

la condition de mesure b est choisie de façon que par le contact électrique il circule un courant de l'ordre de 65 % à 85 %, de préférence d'environ 75 % du courant de court-circuit de la cellule solaire dans des conditions normales.

11. Procédé selon au moins une des revendications précédentes,
**caractérisé en ce**
**que** les densités de courant à l'obscurité ($J_{D,a}(x_i)$, $J_{D,b}(x_i)$) sont décrites au moyen d'un modèle à une diode, en particulier selon les formules 3a et 3b :

$$J_{D,a}(x_i) = j_0(x_i)\exp(V_a(x_i)/V_T), \text{ (formule 3a)},$$

$$J_{D,b}(x_i) = j_0(x_i)\exp(V_b(x_i)/V_T), \text{ (formule 3b)}.$$

12. Procédé selon au moins une des revendications précédentes,
**caractérisé en ce**
**qu'**à l'étape A, une autre mesure est effectuée en plus dans une condition de mesure c différente des conditions de mesure a et b et une autre image de tension $V_c(x_i)$ est déterminée,
**que** les densités de courant à l'obscurité sont décrites en plus à l'aide d'une autre grandeur et à l'étape B les caractéristiques électriques à résolution locale de la structure semi-conductrice sont déterminées en fonction au moins des trois images de tension, de préférence
**que** les densités de courant à l'obscurité sont décrites en plus par une résistance parallèle locale $R_p(x_i)$ indépendante de la tension, de préférence selon les formules 4a à 4c :

$$J_{D,a}(x_i) = j_0(x_i)\exp(V_a(x_i)/V_T) + V_a(x_i)/R_p(x_i), \text{ (formule 4a)},$$

$$J_{D,b}(x_i) = j_0(x_i)\exp(V_b(x_i)/V_T) + V_b(x_i)/R_p(x_i), \text{ (formule 4b)},$$

$$J_{D,c}(x_i) = j_0(x_i)\exp(V_c(x_i)/V_T) + V_c(x_i)/R_p(x_i), \text{ (formule 4c)}.$$

13. Procédé selon la revendication 12,
**caractérisé en ce**
**qu'**à l'étape A, une autre mesure est effectuée en plus dans une condition de mesure d différente des conditions de mesure a, b et c et à l'étape A une autre image de tension $V_d(x_i)$ est déterminée,
**que** les densités de courant à l'obscurité sont décrites en plus à l'aide d'une autre grandeur et à l'étape C les caractéristiques électriques à résolution locale de la structure semi-conductrice sont déterminées en fonction au moins des quatre images de tension, de préférence
**que** la densité de courant à l'obscurité est décrite en plus par une deuxième dépendance de diode avec un facteur de diode 2, de préférence selon les formules 5a à 5d:

$$J_{D,a}(x_i) = j_{0,1}(x_i)\exp(V_a(x_i)/V_T) + j_{0,2}(x_i)\exp(V_a(x_i)/2/V_T) + V_a(x_i)/R_p(x_i)$$

$$\text{(formule 5a)},$$

$$J_{D,b}(x_i) = j_{0,1}(x_i)\exp(V_b(x_i)/V_T) + j_{0,2}(x_i)\exp(V_b(x_i)/2/V_T) + V_b(x_i)/R_p(x_i)$$

$$\text{(formule 5b),}$$

$$J_{D,c}(x_i) = j_{0,1}(x_i)\exp(V_c(x_i)/V_T) + j_{0,2}(x_i)\exp(V_c(x_i)/2/V_T) + V_c(x_i)/R_p(x_i)$$

$$\text{(formule 5c),}$$

$$J_{D,d}(x_i) = j_{0,1}(x_i)\exp(V_d(x_i)/V_T) + j_{0,2}(x_i)\exp(V_d(x_i)/2/V_T) + V_d(x_i)/R_p(x_i)$$

$$\text{(formule 5d).}$$

14. Procédé selon au moins une des revendications précédentes,
    **caractérisé en ce**
    **que** les images de tension déterminées à l'étape A sont débarrassées des bruits de mesure et d'autres artefacts de mesure en corrigeant les images de luminescence brouillées par des filtres de netteté, de préférence des filtres de Wiener.

15. Procédé selon au moins la revendication 3 ou 5,
    **caractérisé en ce**
    **qu'**à l'étape A, au moins une autre mesure est effectuée dans une autre condition de mesure différente des conditions de mesure a et b et au moins une autre image calibrée en tension est déterminée et à l'étape B, un système d'équations surdéterminé est résolu, de préférence selon la méthode des moindres carrés.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- AU 2007001050 W

**In der Beschreibung aufgeführte Nicht-Patentliteratur**

- **WÜRFEL, P. et al.** Diffusions lengths of silicon solar cells from luminescence images. *Journal of Applied Physics,* 2007, vol. 101 (123110), 1-10
- **M. GLATTHAAR ; J. GIESECKE ; M. KASEMANN ; J. HAUNSCHILD ; M. THE ; W. WARTA ; S. REIN.** *Journal of Applied Physics,* 2009, vol. 105, 113110, 1-5
- **T. TRUPKE ; E. PINK ; R. A. BARDOS ; M. D. AB-BOTT.** *Applied Physics Letters,* 2007, vol. 90, 093506-13
- **M. GLATTHAAR ; J. GIESECKE ; M. KASEMANN ; J. HAUNSCHILD ; M. THE ; W. WARTA ; S. REIN.** Spatially resolved determination of the dark saturation current of silicon solar cells from electroluminescence images. *Journal of Applied Physics,* 2009, vol. 105, 113110
- **DAVID MARR ; ELLEN CATHERINE HILDRETH.** *Theory of Edge Detection. In Proceedings öf the Royal Society of London,* 1980, vol. 207, 187, 217
- **R. A. SINTON ; A. CUEVAS.** *Applied Physics Letters,* 1996, vol. 69, 2510-2
- **NORBERT WIENER.** Extrapolation, Interpolation, and Smoothing of Stationary Time Series. Wiley, 1949